(19) Europäisches Patentamt
European Patent Office
Office européen des brevets

(11) Publication number: **0 129 562**
**B1**

(12) # EUROPEAN PATENT SPECIFICATION

(45) Date of publication of patent specification: **13.01.88**

(51) Int. Cl.$^4$: **C 08 G 73/10,** H 01 L 31/02

(21) Application number: **83903874.2**

(22) Date of filing: **07.11.83**

(86) International application number:
**PCT/US83/01752**

(87) International publication number:
**WO 84/02529 05.07.84 Gazette 84/16**

(54) **Solar cell comprising a protective polyimide coating and method for protecting solar cells.**

(30) Priority: **20.12.82 US 451137**

(43) Date of publication of application:
**02.01.85 Bulletin 85/01**

(45) Publication of the grant of the patent:
**13.01.88 Bulletin 88/02**

(84) Designated Contracting States:
**DE FR GB**

(56) References cited:
**DE-A-2 536 350**
**FR-A-1 399 078**
**FR-A-2 137 937**
**GB-A-1 216 505**

(73) Proprietor: **Hughes Aircraft Company**
**7200 Hughes Terrace P.O. Box 45066**
**Los Angeles California 90045-0066 (US)**

(72) Inventor: **DUPONT, Preston, S.**
**9046 Bertrand Avenue**
**Northridge, CA 91325 (US)**
Inventor: **BILOW, Norman**
**16685 Calneva Drive**
**Encino, CA 91436 (US)**

(74) Representative: **Kuhnen, Wacker & Partner**
**Schneggstrasse 3-5 Postfach 1729**
**D-8050 Freising (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 129 562 B1

Courier Press, Leamington Spa, England.

**Description**

This invention relates to a solar cell comprising a photoreactive layer, a primer coating on said photoreactive layer and a protective polymeric coating on said primar coating. The protective polymeric coatings have desirable characteristics for use in outer space. This invention further relates to a method for applying to a solar cell protective polymeric coating.

Polymeric coatings for solar cells are required to provide a high degree of solar radiation protection. Conventional polyimides have the requisite thermal stability, but they are colored, and thus absorb in the visible portion of the solar spectrum which reduces performance and generates heat which promotes degradation. Other polymers discolor excessively or lose structural integrity for various other reasons, such as instability to solar protons, electrons, or ultraviolet radiation. When these polymer coatings discolor, the portion of solar spectrum transmitted to the solar cells is reduced, thus effectively reducing the solar cell efficiency.

In the prior art, coatings such as polyurethanes, epoxies, polyesters and polyimides, were evaluated and found to have inadequate stability for various reasons. Perfluorinated aliphatic hydrocarbons, such as FEP Teflon® (tetrafluoroethylene hexafluoropropylene copolymer), had a better potential, but had inadequate stability. Further, it is necessary to employ an adhesive or a fusion process in order to apply the Teflon® or other polymer coating to the solar cell itself. Usually such an adhesive is a silicone. However, after a period of time, the adhesive or fusion boundary fails and the Teflon® becomes separated from the solar cell, thereby accelerating deterioration and failure of the cell.

Because of the limitations of known polymers heretofore used or considered for solar cells, and particularly for solar cells positioned in outer space, it was necessary to employ a quartz cover over the solar cell itself, in order to protect the cell against low energy particles such as low energy proton bombardment. However, the quartz layer was usually quite heavy (relative to a polymeric coating). This quartz layer thus increased the overall weight and made introduction of the solar cell into very large arrays much more difficult and costly.

Some of the commonly used protective covers for solar cells are formed of fused silica. These fused silica layers usually require a multi-layer filter to effectively filter out all ultraviolet radiation, as for example, that radiation less than 0.35 micrometer (μm), to protect the adhesive, (e.g., a silicone adhesive) from darkening and losing transmission and hence power. Another protective cover commonly used is Ceria® namely a cerium oxide doped glass micro-sheet. This glass sheet has a natural cut-on frequency of about 0.35 μm and hence does not require a multi-layer filter for adhesive protection. The Ceria® glass sheet does provide for radiation stability.

In addition to the foregoing, a fused silica without a multi-layer filter has been used with the FEP Teflon® as the adhesive. This combination is quite effective in view of the fact that glass processing is minimized. However, the overall covered solar cell is still too heavy for use as a space cell in extremely large solar cell arrays.

The method of protecting solar cells which is currently used to a large degree involves the adhesive bonding of a thin $ZnO/Ta_2O_5$ coated quartz coverslide onto the solar cells with a silicone adhesive. The multi-layer $ZnO/Ta_2O_5$ coating on the quartz is a solar radiation cut-off coating which prevents damaging solar radiation (approximately less than 0.32 m) from penetrating through the quartz into the silicone adhesive. Although this means of protecting solar cells is effective, it is too expensive and impractical to apply to massive solar arrays, such as those which would be required for capturing solar radiation on a massive scale in space and transmitting it to earth. This technique is practical only for relatively "small" devices such as communication satellites where the added costs can be tolerated. It is not practical for large size applications, e.g., acre size applications.

Consequently, there still exists a need for a much more reliable, light weight protective coating for solar cells, and particularly for those solar cells which are to be exposed to outer space environments. The prior art cover materials or coating materials such as quartz and the other polymers, are of limited effectiveness. The polymer systems, particularly, suffer from the disadvantage in that they exhibit loss of transmission, cracking and loss of adhesion to the cell after exposure to solar ultraviolet radiation for any reasonable period of time. Further, adhesion is affected materially after subjection to the outer space environments. Consequently, the critical properties for solar cell coatings include the property of being resistant to ultraviolet radiation and maintaining optical clarity, even after a period of time. These coatings must also be resistant to degradation by low energy protons and exhibit good adhesion to the cell after some thermal cycling. Further, they must be formulated for ease of application to the solar cells without any damage to the cell itself. In addition, the coatings must be formulated to be more cost effective than the previously and presently used quartz and glass systems.

U.S. Patent No. 3,356,648 corresponding to FR—A—1399 078 discloses linear polyimides derived from the hexafluoroisopropylidene bridged diamine, such as dianiline, and tetracarboxylic dianhydride. These polyimides are useful as shaped structures and for wrappings, packaging and the like.

U.S. Patent No. 3,959,350 discloses linear polyimides similar to those of U.S. Patent No. 3,356,648, but which do not have hexafluoroisopropylidene groups bridging the amine moieties. These polyimides are useful as molding compounds, and for preparing self-supporting film structures and composites. However,

these polyimides are not colorless. The lack of transparency and the other physical characteristics, such as processability of these polyimides, render them ineffective as solar cell coatings.

According to the invention, a solar cell comprising a photoreactive layer and a primer coating on said phororeactive layer is characterized by a substantially colourless transparent protective polymeric coating on said primer coating, said polymeric coating essentially consisting of a polyimide having the recurring structural unit:

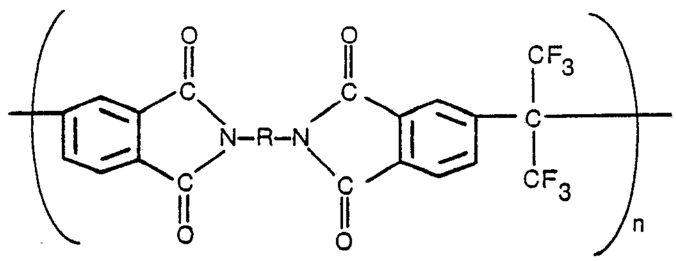

where R is:

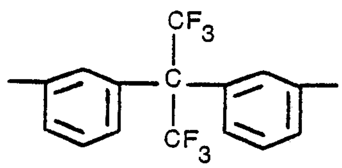

or

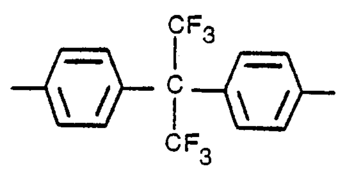

and where n is a number ranging from 10 to about 2000.

The protective coating of the polyimide has the following specific properties.

The polyimide (1) is colorless, (2) is transparent to the solar radiation in the visible light spectrum, (3) is relatively non-brittle, (4) has a high degree of thermal stability, (5) readily transmits solar radiation without appreciable degradation, (6) is heat resistant, (7) does not degrade significantly when exposed to ultraviolet radiation, and (8) is highly effective in protecting against low energy particles, such as proton particles, by effectively absorbing such particles.

In a preferred embodiment, the coating is formed from a polyimide composition which has the recurring structural unit shown below:

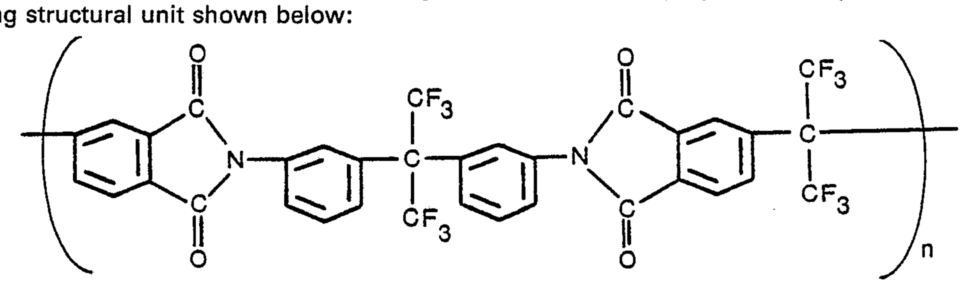

IV

where n is a number ranging from 10 to about 1000.

The method for applying to a solar cell a polymeric coating of the preferred embodiment of the invention comprises:

a) applying a solution of polyamic acid to a solar radiation transmitting component of a solar cell, said polyamic acid having the recurring structural unit:

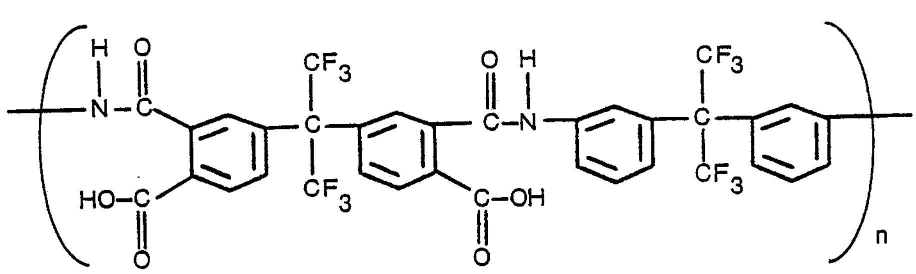

V

where n is a number ranging from 10 to about 1000; and

b) heating said polymeric acid to convert same to said polyimide in the form of a film having the above recurring structural unit (IV).

It has been found that the above polyimide, particularly of structure IV above, when applied as a coating to a solar cell has excellent resistance to degradation from solar radiation and particularly radiation in the ultraviolet wave length range. The film also has remarkable proton absorption capabilities. It has

been noted that no other polymer coatings evaluated to date provided the degree of solar radiation protection afforded by the polyimide coatings of the structure of formula I above, and especially of formula IV while providing the advantage of these coatings.

More particularly, the above polyimide coating is highly suitable for solar cell coating application because of its unique combination of properties. This unique combination of properties includes their excellent thermal stability, which is at least equivalent to that of other aromatic polyimides, transparency in films, colorless nature, stability to ultraviolet radiation, and ability to protect against low energy proton and electron bombardment. This combination of properties is essential for a coating to be useful in the protection of solar cells.

A particular advantage of the solar cell coatings of this invention is their capability for use without the quartz cover heretofore employed on solar cells and without the need for an adhesive layer susceptible to ultraviolet light degradation.

This invention prossesses many other advantages and has other purposes which may be made more clearly apparent from a consideration of the forms and compositions in which it may be embodied. They will now be described in detail for the purposes of more fully setting forth the general principles of the invention, but it is to be understood that such detailed description is not to be taken in a limiting sense.

In the accompanying drawing, the Figure is a vertical section view of a solar cell having a coating in accordance with the present invention applied thereto.

Referring now in more detail and by reference characters to the drawing, there is shown a solar cell having a polyimide coating as hereinafter described. The photocell itself generally comprises a base of p-type semiconductor material which constitutes a p-layer 10 and which is doped on one surface with a n-type materal forming an n-layer 12 having a p-n junction 14 therebetween.

A p-layer electrode 16 is attached to the bottom side of the p-layer 10 for an electrical conductor to be connected thereto. An n-layer electrode 18 may be connected to the n-layer 12 to enable an electrical conductor to be connected thereto. The n-layer electrode usually includes a number of so-called relatively thin fingers extending throughout the surface area of the n-layer so as to avoid any substantial interference with visual light radiation impingement on the photocell.

The photoreactive layers or so-called "photovoltaic" layers including the n-layer 12 and p-layer 10 and junction 14 may adopt the form of a silicon material or it may be a III—V compound such as gallium arsenide, gallium arsenide-phosphide, etc. Other photo-voltaic materials well known in the art may be employed and may be properly doped.

In many cases, an anti-reflective coating 20 may be employed and would be deposited directly on the active surface of the cell prior to application of the polyimide protective coating. A suitable anti-reflective coating is a combination of $TiO_x$ and $Al_2O_5$, $Ta_2O_5$ or $SiO_x$.

Prior to the application of a polyimide coating 22 prepared in accordance with the present invention, a primer coating 24 may be applied to the upper surface of the n-layer 12 or to the anti-reflective coating 20, if employed. The primer coating 24 would generally increase the adhesion of the polyimide coating to the solar cell and particularly to the upper surface of the anti-reflective layer 20 thereof. A typical primer for this purpose is a silane adhesion promoter, such as aminopropyltrimethoxysilane. Other silane adhesion promoters are also known in the art and might also be used for this purpose.

The polyimide of formula IV above is prepared by the reaction of substantially equal molar proportions of the two monomers 2,2-bis(3-aminophenyl)hexafluoropropane and 4,4'-hexafluoroisopropylidene[bis-pthalicanhydride)], in a solvent for such monomers. The solvents which can be used include, for example, tetrahydrofuran, N-methyl pyrrolidinone, N-methylformamide, dimethylformamide and N,N-dimethylacetamide and mixtures thereof. The resulting polyamic acid solution can be cast as a film and the film imidized to the polyimide structure IV above. Both the polyamic acid and the polyimide have an inherent viscosity of at least 0.1, usually 0.3—0.5. The inherent viscosity of the polyimide is measured at 30°C as a 0.5% solution in a suitable solvent, such as cold concentrated (96%) sulfuric acid, or methanesulfonic acid.

As noted above, in preparing the coated solar cells according to the invention, a solution of the polyamic acid precursor of formula V above in a solvent, such as tetrahydrofuran, at a concentration of about 10 to about 30% of the polyamic acid, can be used as a varnish for application to the active surface of a solar cell.

The varnish or solution of the polyamic acid precursor can be coated over the primer coating 24 of the solar cell in any suitable manner, for example, by dipping, electrocoating, spraying, electrostatic spraying and the like. Spraying is a convenient method of application, as contrasted, for example, to the use of Teflon applied as a solar coating according to the prior art, and which requires application of a film. A 15% solids content solution of the polymer in N-methylpyrrolidinone or dimethylformamide has been found to be effective. The solution is sprayed after applying the primer (Union Carbide A1100, aminopropyltrimethoxysilane) from a 5% solution in ethanol. The amount of the polyamic acid in the solvent will vary depending primarily on the type of sprayer or other coating means which is used. The solid content of the polyamic acid in the solvent solution can vary greatly and could be as high as 30% in tetrahydrofuran and in which solution dimethylformamide can be present in an amount of normally as least 60%.

After application of the polyamic acid varnish to the solar cell, that is, over the primer, the solvent is essentially evaporated off and the amic acid polymer is converted into the imidized or polyimide structure of formula IV by heating such amic acid polymer at about 250°C. Lower temperatures, such as at 120°C, can

also be used to promote the imidization, but the reaction rate is slower and the elimination of solvent residues is slower. Preferred imidization temperatures range between about 160°C and 250°C. The polyimide coating may also be dried at about 175°C (350°F) in a vacuum bag. Thinner coatings (about 0.1 mil or $2.54 \times 10^{-6}$m thick) can be dried and then cured for 1 to 2 hr. at about 250°C (485°F) in a vacuum bag. However, the preferred temperature for effecting imidization is that which provides the best solar cell performance, and this may vary depending upon the specific type of cell and the specific batch of amic acid polymer available.

The polyimide film 22 thus formed is generally a very thin layer, as is the silane primer film. The polyimide film itself is preferably about $5.08 \times 10^{-6}$ to $1.27 \times 10^{-5}$m (0.2 to 0.5 mil) thick. However, the practical minimum thicknes is about $2.54 \times 10^{-6}$m (0.1 mil). There is no absolute maximum thickness, except that the film should be as thin as possible and yet provide the desired characteristics to minimise weight of the solar cell.

The invention is further illustrated by, but not limited, to, the following examples:

### Example I

This example I dislcoses the preparation of the polyimide and its casting into a film.

A 100 ml three-necked flask was fitted with a stirrer and gas inlet and outlet tubes. The flask was charged with a solution of 2,2-bis(3-aminophenyl)hexafluoropropane. (1.6344 grams, 0.004890 mole) in 30 ml of purified N,N-dimethylacetamide. Under an argon atmosphere at room temperature and with good stirring, powdered solid 4,4'-hexafluoroisopropylidenebis(phthalic anhydride) (2.1700 grams, 0.004890 mole) was added over a three minute period. The solution was stirred overnight under argon. The solution increased in viscosity during this time. A clear colorless film could be cast from the solution and after drying at 75°C in an air circulating oven, the film could be imidized by heating above 200°C to form a clear and colorless film after imidization.

### Example II

A solution of varnish of about 15% of the polyamic acid precursor of formula V above in 25% tetrahydrofuran, and containing about 60% of dimethylformamide was prepared in a manner as essentially dislcosed in Example I above. The varnish was applied by spraying over the silica covers of a K6 3/4 solar cell, where K6 3/4 is an arbitrary numerical designation for a shallow diffusion 10 ohm-cm silicon solar cell with a back surface field and reflector.

After application of the amic acid coating to the solar cell, the coating was heated at about 250°C for a period of about 60 minutes, causing substantially all of the solvent to evaporate off, and converting the polyamic acid to a colorless transparent film of the polyimide of structure IV above. A $1.27 \times 10^{-5}$M (0.5 mil). thick colorless transparent polyimide coating was thus formed on the solar cell.

In a 1200 hour test of the $1.27 \times 10^{-5}$m (0.5 mil). polyimide coating of the type specified above, under a Xenon light source equivalent to 1.5 suns of UV exposure, the net loss in short circuit ($I_{sc}$) corresponding to UV transmittance loss, showed an estimated net UV loss ($I_{sc}$) of only 8.1%, and with a $5.08 \times 10^{-6}$m (0.2 mil). polyimide coating, was only 8.4%. This loss was an order of magnitude less than that which has been observed with other polymeric coatings such as polyurethanes, epoxies of polyesters, indicating only very minor degradation of the polyimide coating due to UV exposure as compared to other polymeric coatings.

### Examle III

Thermal cycling of the polyimide coated solar cells [$5.08 \times 10^{-6}$ and $1.27 \times 10^{-5}$m (0.2 and 0.5 mil). coating] for Example II (room temperature to liquid nitrogen, 25 cycles) showed no loss of adhesion, via a tape pull test, of the coating to the cell substrate. The tape pull test involves the application of an adhesive tape, such as a Scotch Brand® number 600 tape or the equivalent, to the solar cell and particularly the n-layer electrode and the p-layer electrode surfaces. The tape is pulled away from these contacts or electrodes with a continuous pull. The pull is initiated at one end and progresses toward the other. The cell is then examined for conformance to a desired adhesion level.

Exposure of the coated cells [$5.08 \times 10^{-6}$m (0.2 mil) and $1.27 \times 10^{-5}$m (0.5 mil) coating] to simulated space radiation showed essentially no loss in short circuit current. Dosages of $1 \times 10^{11}$ protons/cm$^2$ (50 KeV) and $2 \times 10^{11}$ protons/cm$^2$ (50 KeV) gave identical results. Spectral response was measured before and after proton exposure. No significant changes were noted, thus indicating resistance of the polyimide solar cell coatings to proton radiation.

Several additional tests were conducted with the standard 10 ohm-cm shallow diffused silicon solar cells designated as the K6 solar cells. These cells had a back surface field and a back surface reflector. In some cases, tests were conducted with solar cells having a textured front surface designated as the K—7 cells. Tests were generally conducted with thicknesses of the polyimide films of about $5.08 \times 10^{-6}$ and $1.27 \times 10^{-5}$m (0.2 and 0.5 mil). Further, the thickness variation of the polyimide layer did not apparently have any significant influence on the amount of ultraviolet degradation. Consequently, relatively thin films can be employed.

From the foregoing, it is seen that the invention provides an improved polymer coated solar cell with a specific polyimide coating having the following advantages: a colorless polymeric coating is provided which readily transmits solor energy, does not degrade significantly when exposed to proton radiation,

electron radiation and ultraviolet light; is transparent and heat resistant, and protects the solar cell from the damaging effects of solar protons, electrons, ultraviolet light and other forms of radiation, is a relatively non-brittle film forming coating, and had processing characteristics which permit it to be readily coated onto solar cells.

The specific polyimide coatings of the present invention obviate the problems heretofore described. These coatings are very light in weight due to the fact that they can be applied in very thin coatings and nevertheless still provide the necessary protection. For example, a $5.08 \times 10^{-6}$m (0.2 mil) coating has been found to be highly effective. Further, the low molecular weight of the polymers may provide for good adhesion to the solar cell itself. In addition, this also enables the adhesion to be maintained over a long lifetime. Indeed, exposure of the solar cells coated with the polyimide resin of the invention with a thickness of $5.08 \times 10^{-6}$m (0.2 mil) to $1.27 \times 10^{-5}$m (0.5 mil) and subjected to simulated space radiation showed essentially no loss in short circuit current. Spectral response was also measured before and after exposure to low energy protons. Once again, no significant changes were noted and the polyimide coated solar cell permitted effective transmission of solar radiation in the range of 0.32 μm to 0.96 μm.

**Claims**

1. A solar cell comprising a photoreactive layer (10 and 12) and a primer coating (24) on said photoreactive layer, characterized by a substantially colorless transparent protective polymeric coating (22) on said primer coating (24), said polymeric coating essentially consisting of a polyimide having the recurring structural unit:

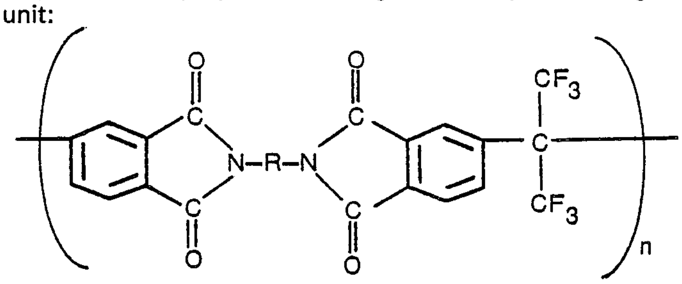

where R is:

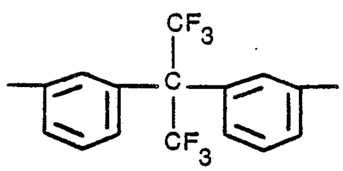

or

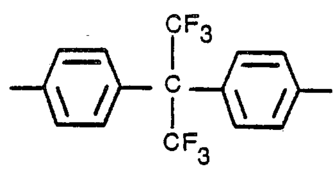

and where n is a number ranging from 10 to about 2000.

2. A solar cell according to claim 1, characterized in said polymeric coating essentially consisting of a polyimide having the recurring structural unit:

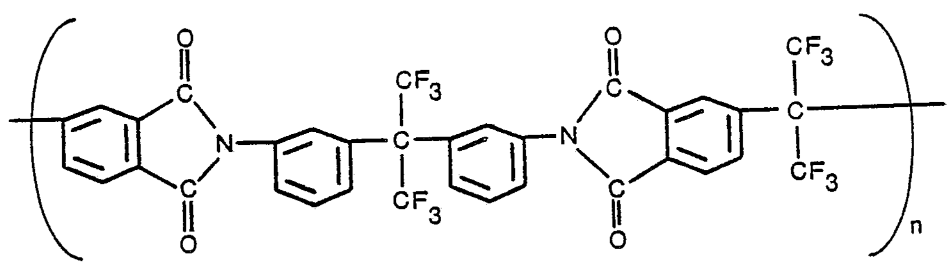

IV

where n is a number ranging from 10 to about 1000.

3. A solar cell according to claim 2, characterized in said polymeric coating having a thickness of $5.08 \times 10^{-6}$ m to $1.27 \times 10^{-5}$m (0.2 — 0,5 mil).

4. A method for applying to a solar cell a substantially colorless, transparent, protective, heat-resistant polymeric coating essentially consisting of a polyimide having the recurring structural unit:

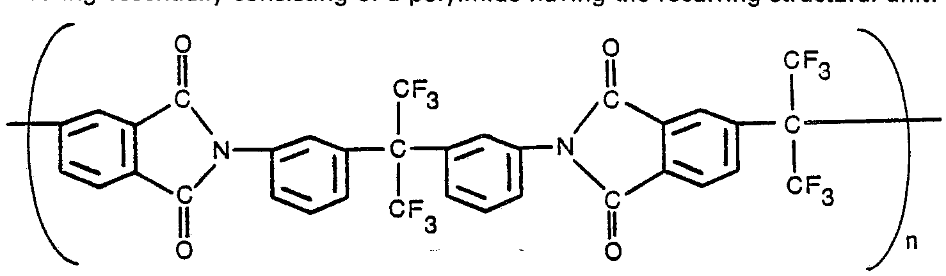

IV

and where n is a number ranging from 10 to about 1000, said coating transmitting radiation and having high resistance to low energy protons, electron bombardment and resistance to ultraviolet light degradation, which comprises:

a) applying a solution of polyamic acid to a solar radiation transmitting component of a solar cell, said polyamic acid having the recurring structural unit:

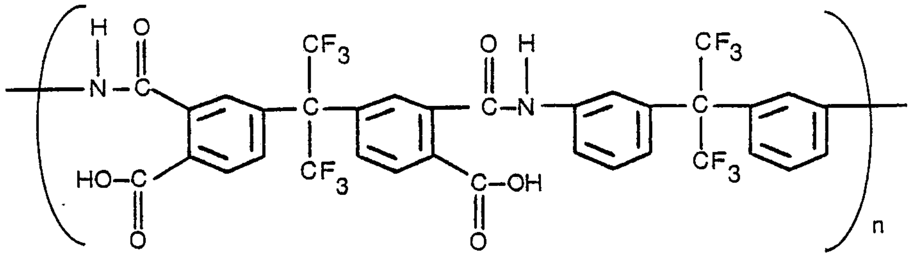

V

where n is a number ranging from 10 to about 1000; and

b) heating said polymeric acid to convert same to said polyimide in the form of a film having the above recurring structural unit.

5. The method as defined in claim 4, said polyamic acid being formed by reacting equal molar proportions of the two monomers 2,2-bis(3-aminophenyl) hexafluoropropane and 4,4'-hexafluoroisopropylidenebis(phthalic anhydride), in a solvent for such monomers.

6. The method as defined in claim 5, said solution containing a solvent selected from the group consisting of tetrahydrofuran, N-methylpyrrolidinone, N-methylformamide, dimethylformamide and N,N-dimethylacetamide, and mixtures thereof.

**Patentansprüche**

1. Solarzelle mit einer photoreaktiven Schicht (10 und 12) und einem Grundüberzug (24) auf der photoreaktiven Schicht, gekennzeichnet durch einen im wesentlichen farblosen transparenten schützenden polymerischen Überzug (22) auf dem Grundüberzug (24), wobei der polymerische Überzug im wesentlichen aus Polyimid mit der sich wiederholenden Struktureinheit besteht:

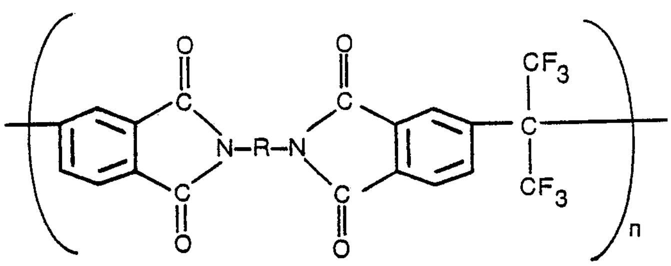

wobei R ist:

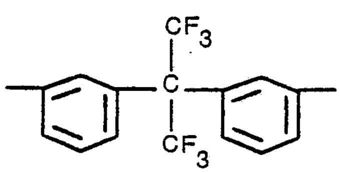

oder

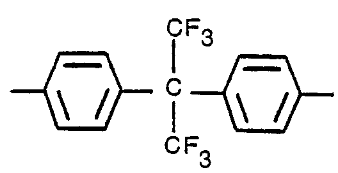

und wobei n eine Zahl zwischen 10 und ungefähr 2000 ist.

2. Solarzelle nach Anspruch 1, dadurch gekennzeichnet, daß der polymerische Überzug im wesentlichen aus Polyimid besteht mit folgender sich wiederholenden Struktureinheit:

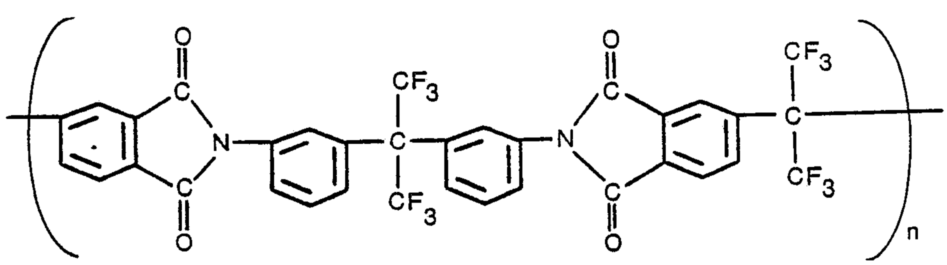

IV

wobei n eine Zahl zwischen 10 und ungefähr 1000 ist.

3. Solarzelle nach Anspruch 2, dadurch gekennzeichnet, daß der polymerische Überzug eine Dicke von $5{,}08 \times 10^{-6}$ m bis $1{,}27 \times 10^{-5}$m (0,2 — 0,5 mil) hat.

4. Verfahren zum Auftragen eines im wesentlichen farblosen, transparenten schützenden, hitzebeständigen polymerischen Überzugs, der im wesentlichen aus Polyimid mit folgender sich wiederholenden Struktureinheit besteht, auf eine Solarzelle:

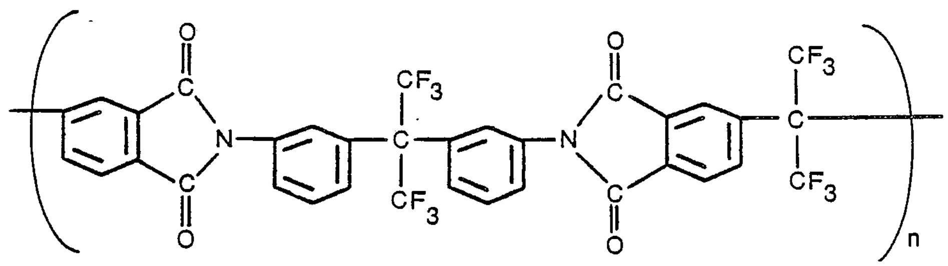

IV

und wobei n eine Zahl zwischen 10 und ungefähr 1000 ist, der Überzug Strahlung durchläßt und eine hohe Beständigkeit gegen Tiefenergieprotonen, Elektronenbeschuß und Beständigkeit gegen Abbau mit ultraviolettem Licht hat, welche aufweist:

a) Auftragen einer Lösung aus Polyamidsäure auf eine für Sonnenstrahlung durchlässige Komponente einer Solarzelle, wobei die Polyamidsäure die folgende sich wiederholende Struktureinheit hat:

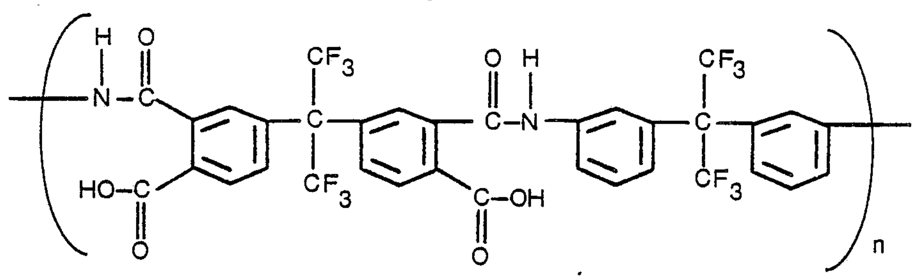

V

wobei n eine Nummer zwischen 10 und ungefähr 1000 ist; und

b) Erhitzen der Polyamidsäure, um dieselbe in Polyimid in Form eines Filmes mit der oberen sich wiederholenden Struktur umzuwandeln.

5. Verfahren nach Anspruch 4, wobei die Polyamidsäure durch Reaktion equimolarer Anteile der zwei Monomeren 2,2-Bis(3-aminophenyl)hexaflouropropan und 4,4'-Hexaflouroisopropylidenbis-(phthalsäureanhydrid), in einem Lösungsmittel für solche Monomere.

6. Verfahren nach Anspruch 5, wobei die Lösung ein Lösungsmittel enthält, welches ausgewählt ist aus der Gruppe, die aus Tetrahydrofuran, N-Methyl-pyrrolidinon, N-Methylformamid, Diethylformamid und N,N-Dimethylacetamid und Gemischen davon besteht.

**Revendications**

1. Cellule solaire comprenant une couche photoréactive (10 et 12) et un revêtement d'accrochage (24) sur ladite couche photoréactive, caractérisée par un revêtement polymérique protecteur transparent (22) pratiquement incolore sur ledit revêtement d'accrochage (24), ce revêtement polymérique étant essentiellement constitué d'un polyimide portant le motif structural récurrent:

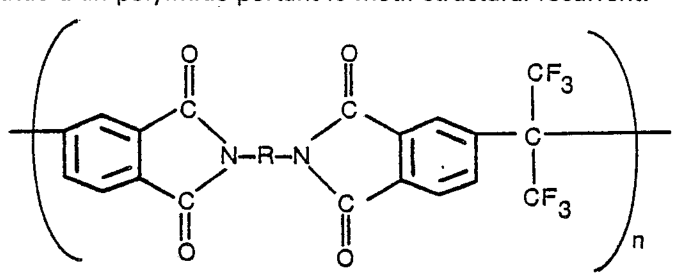

où R représente:

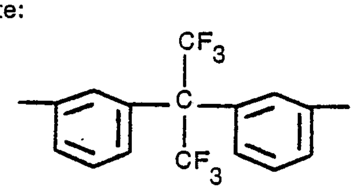

ou

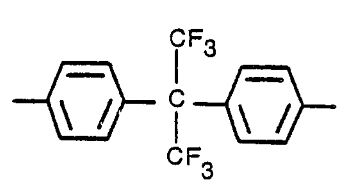

et n est un nombre allant de 10 à environ 2000.

2. Cellule solaire suivant la revendication 1, caractérisée en ce que le revêtement polymérique est essentiellement consititué d'un polyimide portant le motif structural récurrent:

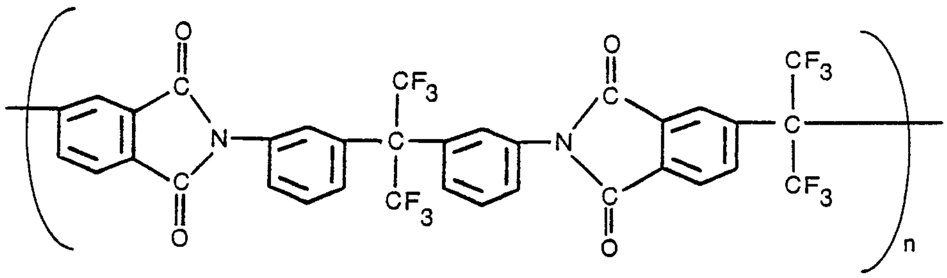

IV

où n est un nombre allant de 10 à environ 1000.

3. Cellule solaire suivant la revendication 2, caractérisée en ce que le revêtement polymérique a une épaisseur de $5{,}08 \times 10^{-6}$m à $1{,}27 \times 10^{-5}$m (0,2 à 0,5 mil).

4. Procédé d'application à une cellule solaire d'un revêtement polymérique thermorésistant protecteur transparent, pratiquement incolore, essentiellement constitué d'un polyimide présentant le motif structural récurrent:

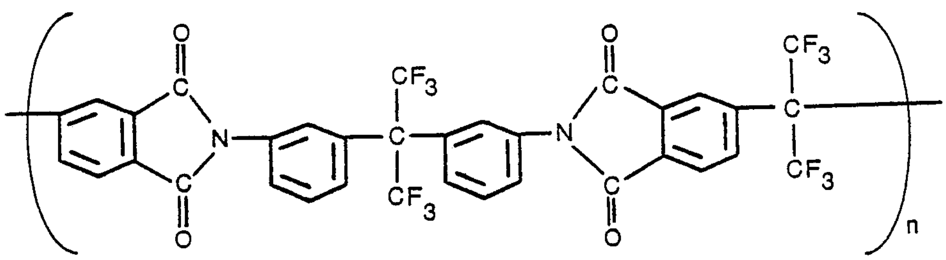

IV

où n est un nombre allant de 10 à environ 1000, ledit revêtement transmettant des radiations et ayant une haute résistance aux protons de faible énergie, à un bombardement par des électrons, et étant doué de résistance à la dégradation par la lumière ultraviolette, procédé qui consiste:

a) à appliquer une solution d'un acide polyamique à un composant d'une cellule solaire transmettant les radiations solaires, ledit acide polyamique présentant le motif structural récurrent:

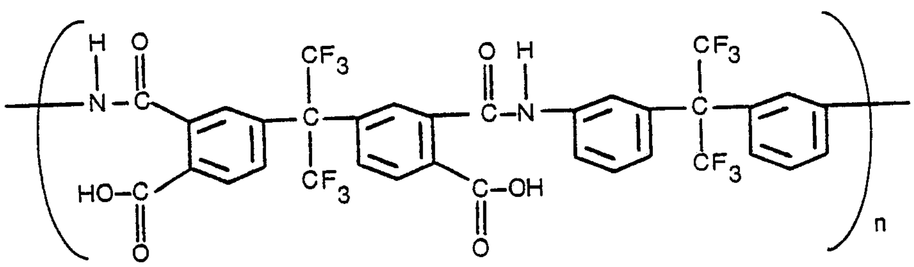

V

où n est un nombre allant de 10 à environ 1000; et

b) à chauffer ledit acide polyamique pour le convertir en ledit polyimide sous la forme d'un film ayant le motif structural récurrent ci-dessus.

5. Procédé suivant la revendication 4, dans lequel ledit acide polyamique est formé par réaction de proportions équimolaires des deux monomères 2,2-bis(3-aminophényl)hexafluoropropane et 4,4'-hexafluoroisopropylidène-bis(anhydride phtalique), dans un solvant pour ces monomères.

6. Procédé suivant la revendication 5, dans lequel ladite solution contient un solvant choisi dans le groupe comprenant le tétrahydrofuranne, la N-méthylpyrrolidinone, le N-méthylformamide, le diméthylformamide et le N,N-diméthylacétamide, et leurs mélanges.

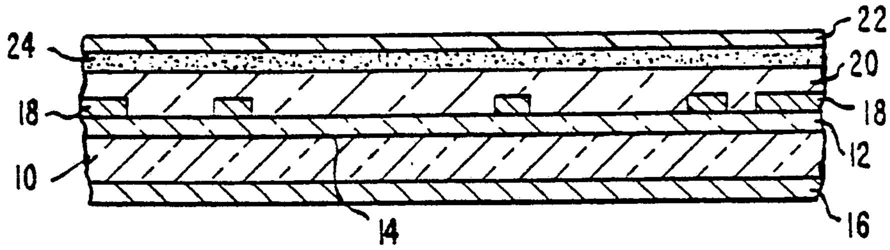
24
22
20
18
18
10
12
14
16